# DEMANDE DE BREVET EUROPEEN

(11) **EP 3 843 248 A1**
(43) Date de publication de la demande: **30.06.2021**
(21) Numéro de dépôt: 21152699.1
(22) Date de dépôt: 21.01.2021
(51) Int. Cl.: H02K 11/05

(54) **MODULE ELECTRONIQUE POUR MACHINE ELECTRIQUE TOURNANTE**

(30) Priorité: 27.12.2019 FR 1915661
(71) Demandeur: VALEO EQUIPEMENTS ELECTRIQUES MOTEUR, 94046 Créteil Cedex (FR)
(72) Inventeur: FAVEROLLE, Pierre, 94046 CRETEIL CEDEX (FR); FANG, Ruyi, 94046 CRETEIL CEDEX (FR); MASSON, Philippe, 38070 St Quentin Fallavier (FR)
(74) Mandataire: Prigent, Pierre

(57) **Abrégé**

L'invention concerne un module électronique (36) pour machine électrique tournante comprenant :
- un boitier (40) comprenant un fond (41) normal à un axe du module (X),
- un ensemble de modules de puissance, monté sur le fond (41) du boitier, apte à redresser un système de courant polyphasé en provenance des phases d'un stator de la machine électronique et éventuellement, apte à alimenter en un système de courant polyphasé les phases du stator,
- une borne positive (43) et une borne négative (44) et plusieurs connexions de phase (60) caractérisé en ce que, pour chacune des connexions de phase, une trace de phase (61) est montée sur le fond pour relier électriquement la connexion de phase et les modules de puissance associées à cette connexion de phase, chaque trace de phase étant disposé axialement entre le fond et une des connexions de phase

## Description

### DOMAINE TECHNIQUE DE L'INVENTION

La présente invention concerne un module électronique pour alimenter machine électrique tournante de véhicule, notamment automobile et une machine électrique équipé d'un tel module.

L'invention trouve des applications dans le domaine des machines électriques tournantes telles que les alternateurs, les alterno-démarreurs, dont les tensions sont par exemple supérieures à 48V.

### ARRIERE-PLAN TECHNOLOGIQUE DE L'INVENTION

Il est connu dans le domaine technique d'utiliser un ensemble de modules de puissances comprenant des interrupteurs électroniques de type MOSFET pour redresser, en mode générateur, un système de courant polyphasé en provenance de phases du stator de la machine électrique et pour alimenter les mêmes phases de ce stator en mode moteur.

Chacun de ces modules de puissance est connecté électriquement à l'une des phases du stator et à l'une des deux bornes d'alimentation B+ et B-.

Ces bornes d'alimentation du module électronique sont reliées électriquement à la batterie et doivent être reliées électriquement aux modules de puissance. Des traces positive et négative parcourant un boitier du module électronique dans lequel sont logés les modules de puissance sont prévues pour leur distribuer du courant.

Chacun de ces modules de puissance est également connecté à une trace de stator par l'intermédiaire d'une connexion de phase. Ces connexions de phase permettent d'amener les phases de l'extérieur du boitier à l'intérieur. Les connexions de phase sont quant à elles connectées aux MOSFET par l'intermédiaire de trace de phase.

Disposer l'ensemble de ces composants dans le boitier requiert un grand nombres d'opérations couteuses en temps.

Il existe un besoin de disposer d'un module électronique dont l'assemblage est simplifié.

### RESUME DE L'INVENTION

La présente invention vise à remédier efficacement à cet inconvénient en proposant un module électronique pour machine électrique tournante comprenant :
- un boitier comprenant un fond normal à un axe du module,
- un ensemble de modules de puissance, monté sur le fond du boitier, apte à redresser un système de courant polyphasé en provenance des phases d'un stator de la machine électronique et éventuellement, apte à alimenter en un système de courant polyphasé les phases du stator,
- une borne positive et une borne négative, la borne positive étant reliée électriquement à l'ensemble de modules de puissance par une trace positive, la borne négative étant reliée électriquement à l'ensemble de modules par une trace négative,
- plusieurs connexions de phase chacune apte à être connectée à une phase de stator, l'ensemble de modules de puissance comprenant, pour chaque connexion de phase, au moins un module positif relié électriquement à la borne positive et à la connexion de phase, au moins un module négatif relié électriquement à la borne négative et à la connexion de phase.

Le module électronique est remarquable en ce que, pour chacune des connexions de phase, une trace de phase est montée sur le fond pour relier électriquement la connexion de phase et les modules de puissance associées à cette connexion de phase, chaque trace de phase étant disposée axialement entre le fond et une des connexions de phase. Les connexions de phase et la trace de phases sont des pièces distinctes. Elles sont connectées ensemble pendant l'assemblage. Les connexions de phases sont des éléments intermédiaires distincts à la fois des phases extérieures du module électronique et des traces de phases.

Une telle disposition permet de simplifier l'assemblage au niveau des connexions de phases en mutualisant les fixations. La succession axiale connexion de phase, traces de phase, fond du boitier permet un assemblage simplifié.

Selon un aspect de l'invention, le module comprend trois connexions de phase. Le système de courant peut être un système triphasé. L'ensemble des modules de puissance positif forme un demi-pont positif. L'ensemble des modules de puissance négatif forme un demi-pont négatif. Pour chaque connexion de phase, l'ensemble de modules de puissance peut comprendre deux modules positifs et deux modules négatifs, respectivement trois positifs et trois négatifs.

Selon un aspect de l'invention, tout ou partie des modules négatifs associées à cette connexion de phase est monté sur la trace de phase.

Selon un aspect de l'invention, les modules de puissance peuvent être des interrupteurs pilotés, par exemple de type MOSFET.

Selon un aspect de l'invention, le module peut comprendre une pluralité d'organe de fixation. Chaque organe de fixation peut être vissé dans une des connexions de phase, dans une des traces de phase et dans le fond du boitier. Un seul organe de fixation permet de mutualiser les fixations. Pour chaque connexion de phase un unique organe de fixation peut être prévu pour fixer la trace de phase à la connexion de phase. Les organes de vissage permettent d'établir la connexion électrique entre les phases et les modules de puissance.

Selon un aspect de l'invention, les moyens de connexion sont des vis.

Selon un aspect de l'invention, chaque connexion de phase peut présenter un trou pour le passage de l'un des organes de fixation. Chaque trace de phase peut présenter un trou pour le passage de l'un des organes de fixation. Les trous de passage peuvent alignés deux à deux.

Selon un aspect de l'invention le boitier peut comprendre une pluralité de protubérance. Chaque protubérance peut recevoir un organe de fixation. Chaque protubérance peut être ménagée dans le fond du boitier. Chaque protubérance peut venir de matière avec le fond du boitier. Chaque protubérance peut être disposée à l'extérieur du boitier. Chaque protubérance peut prendre la forme d'un plot. Chaque pot peut être tronconique.

Selon un aspect de l'invention, chaque connexion de phase peut comprendre une portion isolante et une portion conductrice. La portion isolante peut être en contact avec l'organe de fixation et la portion conductrice peut être en contact avec la trace de phase pour relier électriquement la phase et la trace de phase.

Selon un aspect de l'invention, la portion conductrice de la connexion de phase et la trace de phase sont en contact surfacique. La portion conductrice peut ne pas être en contact avec l'organe de fixation. Cela permet d'éviter les court-circuit entre les connexions de phase et le fond.

Selon un aspect de l'invention, une couche isolante peut être prévue entre chaque trace de phase et le fond pour éviter le contact électrique. La couche isolante peut être mutualisée pour l'ensemble des phases. Selon un aspect de l'invention, la couche ou les couches isolantes peuvent présenter une épaisseur inférieure ou égale à 200 microns, notamment inférieure à 150 microns.

Selon un aspect de l'invention, chaque trace de phase peut être isolée de l'organe de fixation. Chaque trace de phase peut être isolée par un insert isolant entourant l'organe de fixation.

Chaque insert isolant peut venir de matière avec la partie isolante de la connexion de phase. Chaque insert peut être une prolongation axiale en direction du fond.

En variante, chaque insert isolant peut appartenir à la couche isolante. Chaque insert peut être une prolongation axiale en direction de la connexion de phase.

En variante encore, chaque insert peut être un insert indépendant. Chaque insert indépendant peut être monté dans une des ouvertures des traces de phase.

En variante encore, les organes de fixation peuvent être faits en matériau non conducteur électriquement, par exemple en plastique.

Ces différentes solutions permettent d'éviter tout court-circuit entre les connexions de phase et le fond du boitier.

Selon un aspect de l'invention, le boitier peut comprendre comprenant une paroi sensiblement cylindrique s'étendant depuis le fond. Chaque connexion de phase peut traverser la paroi.

Selon un aspect de l'invention, les connexions de phase sont portées par la paroi. Les connexions de phase ne sont pas portées par le fond.

La paroi peut être partiellement non conductrice électriquement, de préférence totalement non conductrice. La paroi peut être continue. La paroi peut s'étendre axialement au-delà des traces positive et négative. La paroi est sensiblement cylindrique.

Selon un aspect de l'invention, chaque connexion de phase peut comprendre un capteur, notamment un capteur de courant. Ces capteurs disposés dans le module dispensent de capteur dans l'environnement machine. Ces capteurs sont au plus près du module de commande, le transfert des signaux acquis est simplifié.

Selon un aspect de l'invention, le module peut comprendre une unité de commande de l'ensemble de modules de puissance. Le boitier peut comprendre un couvercle parallèle au fond dans lequel est ménagé un renfoncement. L'unité de commande peut être disposé dans ce renfoncement. Disposer l'unité de commande dans un renfoncement permet de dissiper efficacement la chaleur dégagée par l'unité de commande car la surface d'échange est augmentée. Le renfoncement peut présenter une forme sensiblement carré. L'unité de commande peut être totalement logée dans le renfoncement. En variante, elle peut être uniquement partiellement dans le renfoncement.

Selon un aspect de l'invention, la trace négative et la trace positive sont superposées l'une sur l'autre au moins partiellement.

La trace négative et la trace positive sont à distance du fond. Les traces à distance du fond ne reposent sur ledit fond. Les modules de puissance peuvent être disposés axialement entre les fond et les traces B+ et B-.

Selon un aspect de l'invention, les traces positive et négative s'étendent linéairement. Par opposition à une trace qui serait surfacique qui s'étend dans plusieurs directions. Linéairement signifie que la direction d'extension est prépondérante sur les deux autres directions.

Selon un aspect de l'invention, les traces positive et négative sont disposées axialement entre le fond et le couvercle. La paroi, le fond et le couvercle peuvent définir un espace fermé. Le couvercle peut être scellé sur la paroi, notamment à la l'aide d'une colle, une fois tous les composants électroniques sont tous placés dans l'espace fermé.

L'invention se rapporte également à une machine électrique tournante comprenant un stator fixe en rotation comprenant une pluralité de phases, un rotor apte à tourner autour d'un axe de rotation de la machine et un module électronique tel que décrit précédemment. Le module électronique est fixe par rapport au stator.

L'axe de rotation de la machine peut être confondu axe l'axe du module. Dans ce cas, le module électronique est disposé axialement d'un côté du stator.

En variante, ces deux axes peuvent être sensiblement perpendiculaire l'un à l'autre. Le module électronique est disposé radialement à l'extérieur du stator.

Chaque phase du stator peut être connectée à une connexion de phase du module électronique.

### BREVE DESCRIPTION DES FIGURES

D'autres avantages et caractéristiques de l'invention apparaîtront à la lecture de la description, illustrée par les figures dans lesquelles :
- [Fig.1] La figure 1 représente une vue schématique en coupe d'une machine électrique équipée d'un module électronique selon l'invention ;

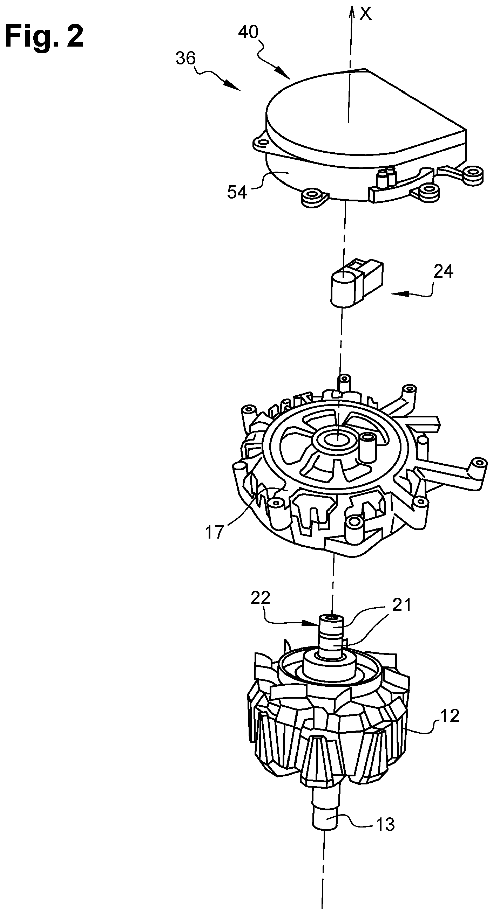

- [Fig. 2] La figure 2 représente, schématiquement et partiellement, une vue en pièce détachée d'une partie de la machine de la figure 1;
- [Fig. 3] La figure 3 représente, schématiquement et partiellement, de face du corps d'un module électronique selon l'invention;
- [Fig. 4] La figure 4 représente, schématiquement et partiellement, un détail du module électronique selon l'invention,

### DESCRIPTION DETAILLEE

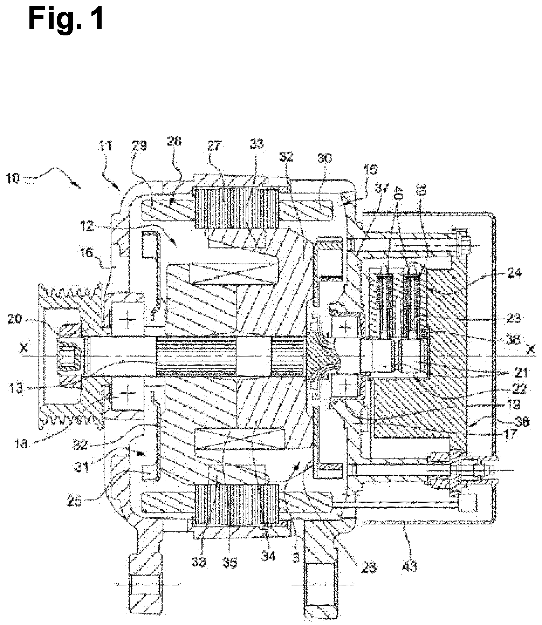

La figure 1 représente une machine électrique tournante 10 polyphasée, notamment pour véhicule automobile. Cette machine électrique tournante 10 transforme de l'énergie mécanique en énergie électrique, en mode alternateur, et peut fonctionner en mode moteur pour transformer de l'énergie électrique en énergie mécanique. Cette machine électrique tournante 10 est, par exemple, un alternateur, un alterno-démarreur ou une machine réversible.

La machine électrique tournante 10 comporte un carter 11. A l'intérieur de ce carter 11, elle comporte, en outre, un arbre 13, un rotor 12 solidaire en rotation de l'arbre 13 et un stator 15 entourant le rotor 12. Le stator et le carter sont fixes en rotation. Le mouvement de rotation du rotor 12 se fait autour d'un axe de rotation de la machine X.

Dans cet exemple, le carter 11 comporte un palier avant 16 et un palier arrière 17 qui sont assemblés ensemble. Ces paliers 16, 17 sont de forme creuse et portent, chacun, centralement un roulement à billes 18, 19 respectif pour le montage à rotation de l'arbre 13.

Une poulie 20 est fixée sur une extrémité avant de l'arbre 13, au niveau du palier avant 16, par exemple à l'aide d'un écrou en appui sur le fond de la cavité de cette poulie. Cette poulie 20 permet de transmettre le mouvement de rotation à l'arbre 13 ou à l'arbre 13 de transmettre son mouvement de rotation à la courroie.

L'extrémité arrière de l'arbre 13 porte un collecteur 22. Ce collecteur comporte un corps réalisé en matériau électriquement isolant et des bagues collectrices 21 surmoulées dans ledit corps. Les bagues collectrices 21 ont une forme annulaire et sont entrainées en rotation avec le rotor 12. Des balais 23 appartenant à un porte-balai 24 sont disposés de façon à frotter sur les bagues collectrices 21. Le porte-balai 24 est relié électriquement à un ensemble électronique 36 pilotant la tension appliquée aux balais.

Le palier avant 16 et le palier arrière 17 peuvent comporter, en outre, des ouvertures sensiblement latérales pour le passage de l'air en vue de permettre le refroidissement de la machine électrique tournante par circulation d'air engendrée par la rotation d'un ventilateur avant 25 sur la face axiale avant du rotor 12, c'est-à-dire au niveau du palier avant 16 et d'un ventilateur arrière 26 sur la face axiale arrière du rotor, c'est-à-dire au niveau du palier arrière 17. Alternativement, les paliers pourront comporter des conduits permettant le passage d'un liquide de refroidissement.

Dans cet exemple, le rotor 12 est un rotor à griffe. Il comporte deux roues polaires 31. Chaque roue polaire 31 est formée d'un flasque 32 et d'une pluralité de griffes 33 formants des pôles magnétiques. Le flasque 32 est d'orientation transversale et présente, par exemple, une forme sensiblement annulaire. Ce rotor 12 comporte, en outre, un noyau 34 cylindrique qui est intercalé axialement entre les roues polaires 31. Ici, ce noyau 34 est formé de deux demi noyaux appartenant chacun à l'une des roues polaires. Le rotor 12 comporte, entre le noyau 34 et les griffes 33, une bobine 35 comportant, ici, un moyeu de bobinage et un bobinage électrique sur ce moyeu. Par exemple, les bagues collectrices 21 appartenant au collecteur 22 sont reliées par des liaisons filaires à ladite bobine 35. Le rotor 12 peut également comporter des éléments magnétiques interposés entre deux griffes 33 adjacentes.

Dans cet exemple de réalisation, le stator 15 comporte un corps 27 en forme d'un paquet de tôles doté d'encoches, par exemple du type semi fermée ou ouverte, équipées d'isolant d'encoches pour le montage d'un bobinage électrique 28. Ce bobinage 28 traverse les encoches du corps 27 et forment un chignon avant 29 et un chignon arrière 30 de part et d'autre du corps du stator. Le bobinage 28 est connecté, par exemple, en étoile ou encore en triangle.

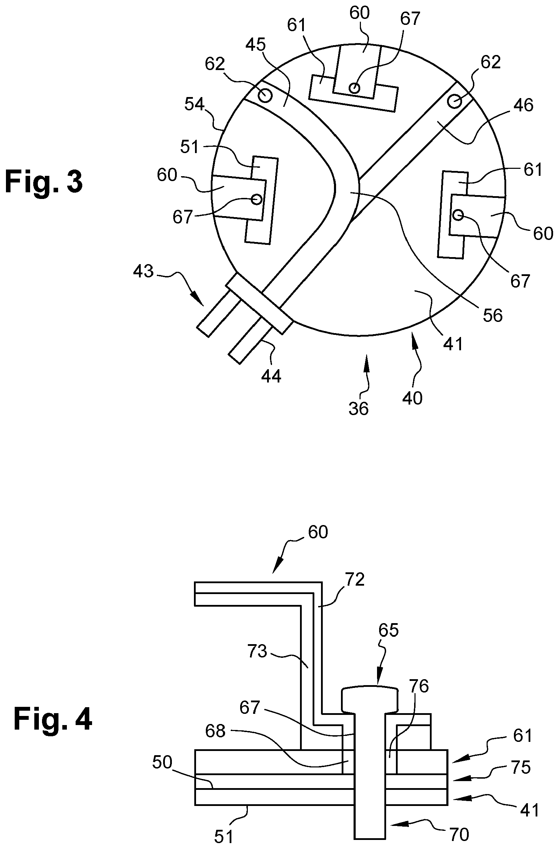

Par ailleurs, le bobinage 28 est formé d'une ou plusieurs phases, ici trois phases. Chaque phase comporte au moins un conducteur traversant les encoches du corps de stator 27 et forme, avec toutes les phases, les chignons. Le bobinage 28 est relié électriquement à un module électronique 36 fixe par rapport au stator et décrit plus en détail en référence aux figures 3 et 4.

Dans cet exemple considéré, le module électronique 36 comprend un boitier 40 comprenant un fond 41, un ensemble de modules de puissance, monté sur le fond du boitier, apte à redresser un système de courant polyphasé en provenance de phases du stator 15 et apte à alimenter en un système de courant polyphasé les phases.

Dans l'exemple considéré, le fond 41 est sensiblement plan et normal à un axe du module, confondu avec l'axe de la machine électrique 10. Le fond est sensiblement circulaire, autour de l'axe du module.

Le fond présente une surface intérieure 50 au boitier 40 et une surface extérieure 51 en regard du stator 15. L'épaisseur du fond peut être comprise entre 5mm et 20mm.

Dans l'exemple considéré, le boitier comprend également une paroi 54, continue, sensiblement cylindrique s'étendant depuis le fond 41 dans la direction opposée au stator 15. La paroi 54 est ici non conductrice. La paroi s'étend axialement au-delà des traces positive et négative.

Bien que non représentée, le boitier comprend également une unité de commande de l'ensemble de modules de puissance et un couvercle parallèle au fond dans lequel est ménagé un renfoncement. L'unité de commande est disposée dans ce renfoncement. Le renfoncement peut présenter une forme sensiblement carré.

Dans l'exemple considéré, la paroi 54, le fond 41 et le couvercle définissent un espace fermé. Le couvercle peut être scellé sur la paroi 54, une fois tous les composants électroniques placés dans l'espace fermé.

Le module électronique 36 comprend également une borne positive 43 et une borne négative 44 pour alimenter en courant l'ensemble de modules de puissance La borne positive 43 est reliée électriquement à l'ensemble de modules de puissance par une trace positive disposée 45 à distance du fond 41 du boitier. La borne négative 44 étant reliée électriquement à l'ensemble de modules de puissance par une trace négative 46 disposée à distance du fond du boitier.

Dans l'exemple considéré la trace positive et la trace négative sont superposées l'une sur l'autre au moins partiellement. Ici sur plus de la moitié de la longueur de la trace négative 46.

Les traces positive 45 et négative 46 sont disposées axialement entre le fond 41 et le couvercle. Plus précisément ; la trace négative 46 est ici disposée entre le fond 41 et la trace positive 45.

Les traces positive 45 et négative 46 sont surmoulées. Une enveloppe en matériau isolant, notamment en plastique, entoure un matériau conducteur, par exemple en cuivre. Les traces positive et négative sont ici à section rectangulaire.

Dans l'exemple considéré, la trace positive 45 et la trace négative 46 s'étendent dans un plan parallèle au fond 41 et sont en contact plan l'une sur l'autre. La distance axiale entre la trace négative 46 et le fond peut être supérieure à deux fois l'épaisseur axiale de l'une des traces.

Dans l'exemple considéré, la trace positive 45 est coudée et la trace négative est rectiligne. La trace positive comprend deux portions rectilignes d'extension radiale formant un coude en leur intersection. L'angle du coude mesuré entre les portions rectilignes est inférieur à 60 degrés, sensiblement égale à 45 degrés. Le coude 56 présente une forme arrondie et traverse l'axe X.

Dans l'exemple considéré, Les bornes positive 41 et négative 42 sont ménagées dans une première zone de cette paroi.la trace positive 45 s'étend depuis la première zone jusqu'à atteindre une deuxième zone de la paroi. La trace négative 46 s'étend depuis la première zone jusqu'à atteindre une troisième zone de la paroi, éloigné de la deuxième zone. Chaque trace s'étend donc d'un bord du boitier 41 à un autre bord du boitier en passant en son centre. La deuxième zone est ici sensiblement à équidistance des première et troisième zones.

Dans l'exemple considéré, le module électronique 36 comprend, trois connexions de phase 60, chacune apte à être connectée à une phase du bobinage 28 du stator 15. Chaque connexion de phase 60 traverse la paroi 54 pour amener électriquement les phases de l'extérieur du boitier 40 à l'intérieur en traversant la paroi 54.

L'ensemble de modules de puissance comprend, pour chaque connexion de phase 60, au moins un, par exemple deux, module positif relié électriquement à la borne positive 43 et à la connexion de phase et au moins un, par exemple deux, module négatif relié électriquement à la borne négative 44 et à la connexion de phase 60. L'ensemble des modules de puissance positif forme un demi-pont positif. L'ensemble des modules de puissance négatif forme un demi-pont négatif. Les modules de puissance peuvent être des interrupteurs pilotés, par exemple de type MOSFET.

Dans l'exemple considéré, les première, deuxième et troisième zones associées aux traces positive 45 et négative 46 sont alternées avec les zones de connexion de phase 60.

Dans l'exemple considéré, le module électronique 36 comprend une deuxième trace positive et une deuxième trace négative montées sur le fond 41 et isolées électriquement dudit fond 41. Ces traces ne sont pas représentées sur les figures 3 et 4. La deuxième trace positive relie électriquement la trace positive 45 et tout ou partie des modules de puissance positifs. La deuxième trace négative relie électriquement la trace négative 46 et tout ou partie des modules de puissance négatifs. Chaque deuxième trace positive et négative peut s'étendre circonférentiellement, notamment depuis la deuxième ou la troisième zone. Une première couche d'isolant peut être prévue entre chaque deuxième trace positive et négative et le fond 41 pour éviter le contact électrique. Chaque trace positive et négative peut être en contact surfacique avec la trace associée pour le passage du courant.

Dans l'exemple considéré, chaque trace positive 45 et négative 46 peut être fixée par vissage à la deuxième trace positive ou négative associée. Un premier organe de fixation, par exemple une vis, peut être vissé dans chaque trace positive ou négative, dans la deuxième trace associée et dans le fond 41. Une première protubérance peut être prévue à l'extérieur du boitier pour recevoir le premier organe de fixation. Chaque première protubérance peut venir de matière avec le fond du boitier. Chaque première protubérance peut prendre la forme d'un plot. Les premiers organes de fixation traversent des premières ouvertures de vissage 62 des traces positive 45 et négative 46.

Dans l'exemple considéré, pour chaque connexion de phase 60, une trace de phase 61 est montée sur le fond 41 pour relier électriquement la connexion de phase 60 et les modules de puissance associées à cette connexion de phase.

Comme on peut le voir à la figure 4, chaque trace de phase 61 est disposée axialement entre le fond 41 et une des connexions de phase 60.

Dans l'exemple considéré, le module comprendre trois organes de fixation 65, qui sont par exemple des vis. Chaque organe de fixation est vissé dans une des connexions de phase 60, dans une des traces de phase 61 et dans le fond 41 du boitier. Un seul organe de fixation permet de mutualiser les fixations. Pour chaque connexion de phase 60 un unique organe de fixation 65 est prévu pour fixer la trace de phase 61 à la connexion de phase 60.

Dans l'exemple considéré, chaque connexion de phase 60 présente un trou 67 pour le passage de l'un des organes de fixation 65. Chaque trace de phase 61 présente également un trou 68 pour le passage de l'un des organes de fixation 65. Les trous de passage sont alignés deux à deux.

Dans l'exemple considéré, le boitier 40 comprend trois protubérances 70 recevant un organe de fixation 65. Chaque protubérance 70 est ménagée dans le fond 41 du boitier. Chaque protubérance 70 vient de matière avec le fond 41 du boitier et est disposée à l'extérieur du boitier 40. Chaque protubérance 70 prend ici la forme d'un plot tronconique. Les premières protubérances et les protubérances peuvent être identiques.

Dans l'exemple considéré, chaque connexion de phase 60 comprend une portion isolante 72 et une portion conductrice 73. La portion isolante 72 est en contact avec l'organe de fixation 65 et la portion conductrice 73 est en contact surfacique avec la trace de phase 61 pour relier électriquement la phase et la trace de phase 61. La portion conductrice n'est pas en contact avec l'organe de fixation 65.

Dans l'exemple considéré, une couche isolante 75 est prévue entre chaque trace de phase 60 et le fond 41 pour éviter le contact électrique. La couche isolante peut être mutualisée pour l'ensemble des phases 60. La couche ou les couches isolantes 75 peuvent présenter une épaisseur inférieure ou égale à 200 microns, notamment inférieure à 150 microns.

Dans l'exemple considéré, chaque trace de phase 61, peut être isolée de l'organe de fixation. Chaque trace de phase peut être isolée par un insert isolant 76 entourant l'organe de fixation 75. L'insert isolant 76 est ici indépendant. Chaque insert isolant 76 est monté dans une des ouvertures 68 des traces de phase 61.

En variante, chaque insert isolant 76 peut venir de matière avec la partie isolante de la connexion de phase. Chaque insert peut être une prolongation axiale en direction du fond.

En variante, chaque insert isolant 76 peut appartenir à la couche isolante. Chaque insert peut être une prolongation axiale en direction de la connexion de phase.

En variante encore, les organes de fixation peuvent être faits en matériau non conducteur électriquement, par exemple en plastique.

## Revendications

1. Module électronique (36) pour machine électrique tournante comprenant :
- un boitier (40) comprenant un fond (41) normal à un axe du module (X),
- un ensemble de modules de puissance, monté sur le fond (41) du boitier (40), apte à redresser un système de courant polyphasé en provenance des phases d'un stator de la machine électronique et éventuellement, apte à alimenter en un système de courant polyphasé les phases du stator,
- une borne positive (43) et une borne négative (44), la borne positive étant reliée électriquement à l'ensemble de modules de puissance par une trace positive (45), la borne négative (46) étant reliée électriquement à l'ensemble de modules par une trace négative,
- plusieurs connexions de phase (60) chacune apte à être connectée à une phase de stator (15), l'ensemble de modules de puissance comprenant, pour chaque connexion de phase (60), au moins un module positif relié électriquement à la borne positive et à la connexion de phase, au moins un module négatif relié électriquement à la borne négative et à la connexion de phase,
**caractérisé en ce que**, pour chacune des connexions de phase (60), une trace de phase est montée sur le fond pour relier électriquement la connexion de phase et les modules de puissance associées à cette connexion de phase, chaque trace de phase (61) étant disposée axialement entre le fond (41) et une des connexions de phase (60).

2. Module électronique (36) selon la revendication 1, **caractérisé en ce que** le module électronique (36) comprend une pluralité d'organes de fixation (65), chaque organe de fixation (65) est vissé dans une des connexions de phases (60), dans une des traces de phase (61) et dans le fond (41) du boitier.

3. Module électronique (36) selon la revendication précédente, **caractérisé en ce que** le boitier (40) comprend une pluralité de protubérance (70), chaque protubérance recevant un organe de fixation (65).

4. Module électronique (36) selon la revendication précédente, **caractérisé en ce que** chaque protubérance (70) vient de matière avec le fond (41) du boitier et est disposée à l'extérieur du boitier (40).

5. Module électronique (36) selon l'une quelconques des revendications précédentes, caractérisé chaque connexion de phase (60) comprend une portion isolante (72) et une portion conductrice (73), la portion isolante étant en contact avec l'organe de fixation (65) et la portion conductrice étant en contact avec la trace de phase (61) pour relier électriquement la phase et la trace de phase (61).

6. Module électronique (36) selon l'une quelconques des revendications précédentes, **caractérisé en ce qu'**une couche isolante est prévue entre chaque trace de phase et le fond pour éviter le contact électrique.

7. Module électronique (36) selon l'une quelconques des revendications 2 à 6, **caractérisé en ce que** chaque trace de phase est isolée de l'organe de fixation par un insert isolant entourant l'organe de fixation.

8. Module électronique (36) selon l'une quelconques des revendications précédentes, le boitier (40) comprenant une paroi (54) sensiblement cylindrique s'étendant depuis le fond, chaque connexion de phase (60) traverse la paroi (54).

9. Module électronique (36) selon l'une quelconque des revendications précédentes, le module électronique (36) comprenant une unité de commande de l'ensemble de modules de puissance, le boitier (40) comprenant un couvercle parallèle au fond dans lequel est ménagé un renfoncement dans lequel est disposé l'unité de commande.

10. Machine électrique (10) tournante comprenant un stator (15) fixe en rotation comprenant une pluralité de phases, un rotor apte à tourner autour d'un axe de rotation de la machine et un module électronique tel que décrit aux revendications 1 à 9, le module électronique (36) étant fixe par rapport au stator (15).
